(19) Europäisches Patentamt

European Patent Office

Office européen des brevets

(11) **EP 0 913 926 B1**

(12) **EUROPEAN PATENT SPECIFICATION**

(45) Date of publication and mention
of the grant of the patent:
**03.03.2004   Bulletin 2004/10**

(51) Int Cl.⁷: **H03F 1/00**, H03F 3/72

(21) Application number: **97830560.5**

(22) Date of filing: **31.10.1997**

(54) **Integrated power amplifier which allows parallel connections**

Integrierter parallele Verbindungen erlaubender Leistungsverstärker

Amplificateur de puissance intégré permettant des connections parallèles

(84) Designated Contracting States:
**DE FR GB IT**

(43) Date of publication of application:
**06.05.1999   Bulletin 1999/18**

(73) Proprietor: **STMicroelectronics S.r.l.**
**20041 Agrate Brianza (Milano) (IT)**

(72) Inventors:
• **Chiozzi, Giorgio**
  **20092 Cinisello Balsamo (Milano) (IT)**

• **Tavazzani, Claudio**
  **27020 Trivolzio (Pavia) (IT)**

(74) Representative: **Botti, Mario**
**Botti & Ferrari S.r.l.,**
**Via Locatelli, 5**
**20124 Milano (IT)**

(56) References cited:
**EP-A- 0 369 716**          **EP-A- 0 613 242**
**US-A- 3 582 675**          **US-A- 3 924 070**
**US-A- 4 236 088**          **US-A- 4 598 252**
**US-A- 5 363 059**

## Description

This invention relates to a power operational amplifier for audio applications, as may be useful in stereo apparatus, amplified cabinet speaker systems, or high-performance TV stereo sets.

Field of the Invention

In particular, this invention relates to an integrated power operational amplifier adapted for parallel clustering with a number of similar amplifiers in order to provide very high output power levels.

Background Art

To enable a number of operational amplifiers to be used in parallel for driving a common load, it has hitherto been necessary to connect ballast resistors between the outputs of each amplifier and the load, effective to equalize the currents from each amplifier.

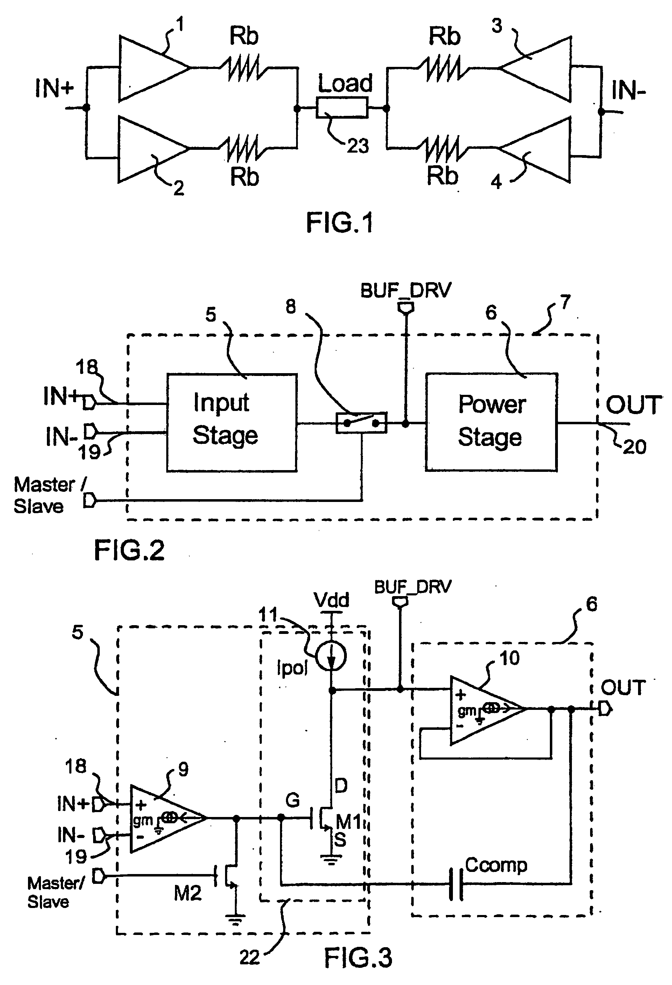

An example of such an arrangement is shown in Figure 1. This figure shows an amplifier bridge system wherein a load 23 is powered from two pairs of operational amplifiers 1, 2 and 3, 4. Each amplifier pair have a ballast resistor Rb placed between the output and the load.

The inclusion of such resistors is made necessary by the large cross-conduction currents brought about by the low output impedance of the amplifiers associated with the presence of gain offset or mismatch, which currents would be circulated among the outputs of the operational amplifiers.

The provision of ballast resistors results in less power being delivered and more power dissipated, as well as in the cost and size of the system being increased. Low Resistance, high-precision power resistors, usually resistance wires, must be employed which are bulky and significantly expensive.

A known prior art solution is disclosed in the US patent No. 4,236,088 concerning a power operational amplifier receiving an input signal on one input terminal and delivering an amplified signal on an output terminal. This document discloses at least one input stage (Q3, Q4) and one power stage (Q9) connected in series in a chain between said input and output terminals; said input stage comprising at least a differential amplifier (Q3, Q4) having first (+) and second (-) input terminals and a gain stage (Q5) connected between the output of said differential amplifier and the input of the power stage for driving said power stage.

A second known solution is disclosed in the US patent No. 4,598,252 disclosing and amplifier structure similar to the previous document and further comprising a control element (23) coupled to the input stage (A4) for selectively disabling and enabling the input stage (A4).

Both documents disclose however very complex circuit structures that are not totally efficient or suitable to provide an operational amplifier adapted for parallel clustering with low power dissipation.

The underlying technical problem of this invention is to provide an integrated power operational amplifier adapted for parallel clustering, such that a number of similar amplifiers can be connected in parallel without requiring ballast resistors, thereby to deliver a high output power with no unnecessary power dissipation.

The technical problem is solved by a power operational amplifier as indicated above and defined in the characterizing portions of Claims 1 to 5.

Summary of the Invention

The solving idea behind this invention is one of providing an integrated type of power operational amplifier which can alternatively be operated in a master mode or a slave mode, whereby a master amplifier can be connected in parallel with one or more slave amplifiers. This system enables very low impedance loads to be driven, and heat to be spread for dissipation over several chips, thereby overcoming the limitations to maximum dissipation which are besetting prior integrated power systems.

In addition, by doing without the ballast resistors, the system can deliver more power and dissipate less of it, for the same supply voltage.

The features and advantages of the circuit according to the invention will be apparent from the following detailed description of embodiments thereof, shown by way of non-limitative examples in the accompanying drawings.

Brief Description of the Drawings

Figure 1 shows a parallel amplifier system according to the prior art.

Figure 2 is a block diagram of an operational power amplifier for parallel clustering, according to related art.

Figure 3 shows a circuit diagram of an operational power amplifier for parallel clustering, according to related art.

Figure 4 shows a power amplifier structure comprising two operational power amplifiers connected in parallel, according to related art.

Figure 5 shows an equivalent circuit for two power stages of two operational amplifiers connected in parallel, according to related art.

Figure 6 shows an alternative block diagram of an operational power amplifier for parallel clustering, according to this invention.

Detailed Description

Shown in Figure 2 is a block diagram of an operational power amplifier 7 adapted for parallel clustering, according to related art. Shown on the diagram are an input stage 5 and a power stage 6 which are connected in series between two input terminals 18, 19 and an output terminal 20 of the amplifier.

For simplicity, circuit blocks or pins of the device not strictly necessary to understand the invention have been omitted from the figure, but would obviously be provided in amplifiers of this kind. For example, the power supply, ground, standby, or mute terminals of the device have been omitted.

Placed between the input 5 and power 6 stages is a buffer element 8 controlled by a master/slave logic signal to disable the input stage 5 while simultaneously separating it from the power stage 6. The input terminal of the power stage 6 is taken out of the amplifier 7 by a terminal BUF_DRV connected to an external pin thereof. This terminal BUF_DRV functions as an output terminal, with the amplifier in the master mode of operation, and as an input terminal with the amplifier in the slave mode.

Thus, the operational amplifier can be configured as either a master or a slave by applying a logic signal to the pin BUF_DRV. An amplifier configured as a master can drive the power stages of possible slave-configured amplifiers, wherein a suitable logic signal disables the input stage.

Thus, the master and slave amplifiers are similar circuit constructions. This allows one integrated circuit model to be used for implementing both the master and slave amplifiers, thereby reducing their designing costs and making for simpler utilization.

Figure 3 shows an example of a circuit scheme implementing the above operational amplifier shown in Figure 2.

In particular, the input stage 5 comprises an input differential amplifier 9 having non-inverting and inverting input terminals connected to respective input terminals 18 and 19 of the device 7, and a gain stage 22 connected with its output to the differential amplifier 9.

The gain stage 22 comprises an n-channel MOS transistor M1 having a gate terminal G outputting to the differential amplifier 9, and a main conduction path D-S connected, in series with a bias current generator Ipol, between a supply terminal Vdd and ground. The drain terminal D of the transistor M1 forms the output of the input stage 5.

The buffer element, shown at 8 in Figure 2, which disables the input stage 5 while simultaneously separating it from the power stage 6, is here an n-channel MOS transistor M2. The transistor M2 has a control terminal controlled by the master/slave logic signal, and a main conduction path placed between the gate terminal G of the transistor M1 and ground. The transistor M2 functions shortcircuiting to ground the input of the gain stage 22 upon the application of a positive logic signal to its control terminal. This condition corresponds to the slave mode of operation of the device.

Conversely, when a low logic signal is applied to the control terminal of the transistor M2, i.e. it is connected to ground, the transistor will not be conducting, and will not affect the operation of the differential amplifier 9 and gain stage 22. This condition corresponds to the master mode of operation of the device.

The power stage 6 is represented here by a transconductance amplifier stage 10. A compensating capacitor Ccomp is connected between the input of the gain stage 22 and the output of the transconductance stage 10. This compensation is called buffer wrapping compensation and is commonly utilized in the power stages of audio amplifiers.

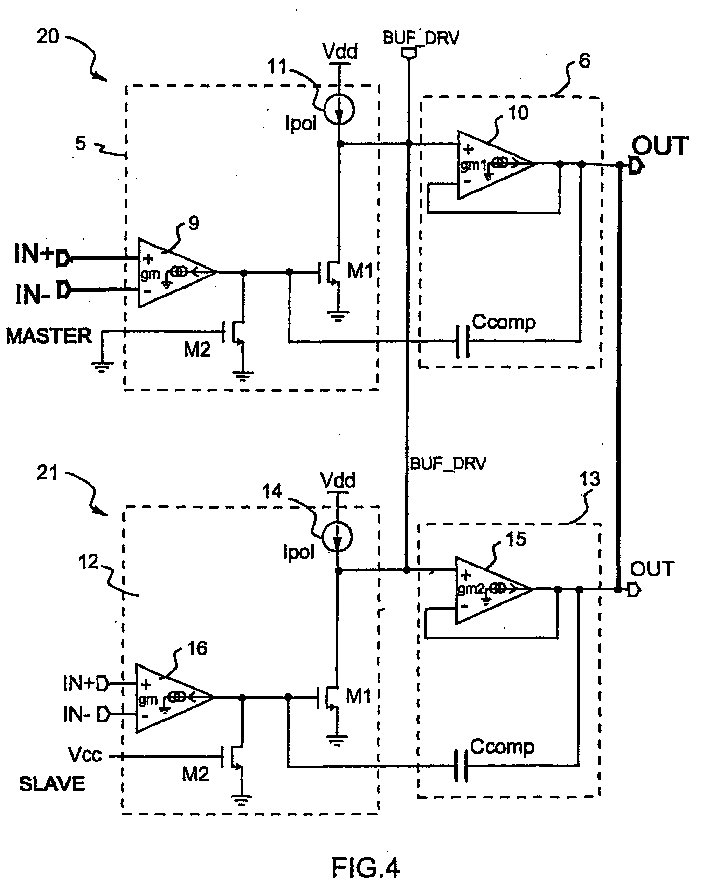

Shown in Figure 4 is a power amplifier structure obtained by connecting two operational amplifiers in parallel together.

A first amplifier 20 is configured for a master mode, whereas the second amplifier 21 is configured for the slave mode. The circuit construction is obviously the same for both amplifiers, since the same integrated device can be used either as master or slave by appropriate configuration.

The gate of the MOS M2 in the first amplifier is connected to ground, whereas the MOS M2 of the second amplifier is kept conducting by the application of a positive voltage Vcc to its gate terminal, thereby cutting off the first two stages of the second amplifier 21.

The power stages 6 and 13 are connected in parallel, the terminals BUF_DRV and output terminals OUT of the two amplifiers 20 and 21 being, in fact, connected in parallel together.

The input stage 5 of the first master amplifier will practically be driving two power stages in parallel.

A third slave-configured amplifier, or more generally a plurality of such amplifiers, could be similarly connected, each with the input stage disabled and the output stage connected in parallel to the output stage of the master amplifier.

Considering a three-stage scheme with buffer wrapping compensation (and with the compensating capacitor Ccomp connected between the input of the gain stage and the output of the amplifier), the slave-mode amplifiers, having their gain stage input shorted to ground, will add no capacitive load to the master gain stage.

On the other hand, where the compensation is provided by connecting a capacitor between the input and the output of each gain stage, the capacitive load toward ground applied by the slave-mode amplifiers to the gain stage of the master amplifier would have to be taken into account. In this case, the number of slave amplifiers that can be connected in parallel to a master amplifier would be a limited maximum.

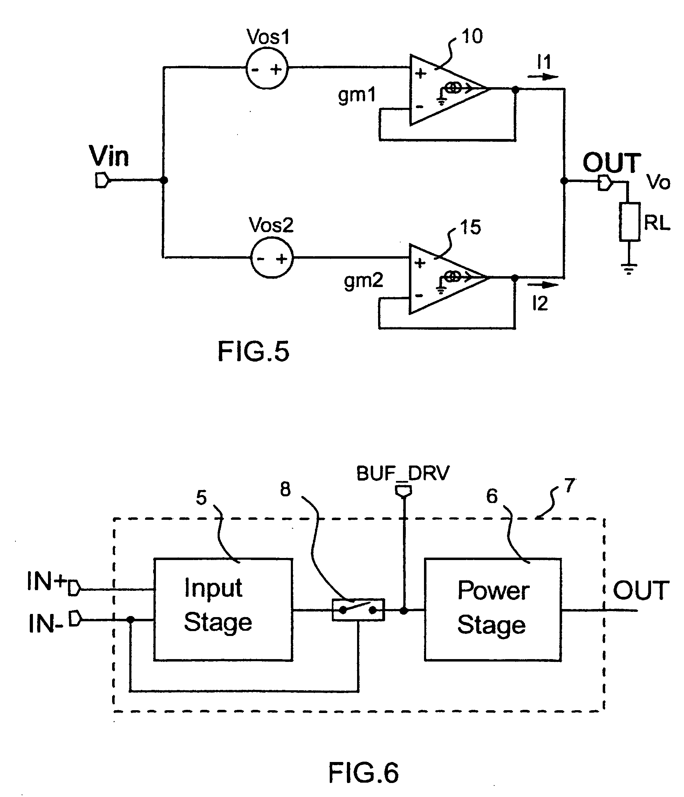

Figure 5 is an equivalent electric diagram for two power stages 10 and 15 connected in parallel which are characterized by respective transconductances gm1, gm2 and offset voltages Vos1, Vos2, appearing at the inputs.

Assuming a resistance $R_L$ to be the load applied to the output OUT, the currents I1 and I2 from the two stages can be expressed in terms of the input voltage Vin, the output voltage Vo, and the input offset voltages Vos1 and Vos 2:

$$I1 = (Vin + Vos1 - Vo) * gm1 \qquad (1.0)$$

$$I2 = (Vin + Vos2 - Vo) * gm2$$

$$Vo = (I1 + I2) * RL$$

At rest, the output voltage Vo is ruled by the feedback, and is zero. The voltage at the inputs of the transconductance stages Vin can be obtained by solving for Vin the expression (1.0), observing that I1=-I2 at rest and substituting with Vo=0:

$$Vin = Vos1*(gm1/(gm1+gm2))-Vos2(gm2/(gm1+gm2)) \qquad (1.1)$$

In this condition, the load current would be zero, and the cross-conduction can be obtained by substituting the expression (1.1) in the first of expressions (1.0):

$$I_{cross}=I1=I2=(Vos1-Vos2)*((gm1*gm2)/(gm1+gm2)) \qquad (1.2)$$

This expression shows that the cross-conduction current $I_{cross}$ increases with the transconductances gm1 and gm2.

A limit is reached for gm1 and gm2 approaching infinity:

$$Lim\ (gm{\to}\infty)\ I_{cross} = \infty \qquad (1.3)$$

The above expression shows that, for the currents delivered by the two amplifier stages connected in parallel to be stable, said stages must be limited transconductance stages.

From equation (1.2), the maximum values for the transconductances gm1, gm2 can be obtained, once the largest input offset current and largest acceptable cross-conduction current are known:

$$gm_{max} = (I_{crossmax}/Vos_{max})$$

The voltage $Vos_{max}$ is equal to the maximum absolute value of the expression Vos1-Vos2.

A condition for the system to operate properly is, therefore, that the power stages of the amplifiers should have a limited transconductance.

An embodiment of a power operational amplifier adapted for parallel clustering, according to the invention, is shown in Figure 6.

The buffer element 8 has here its control terminal connected directly to one of the two input terminals of the amplifier, specifically to terminal 19.

In this case, it will be sufficient to connect this input to a high positive voltage for enabling the buffer element 8, and set the amplifier for the slave mode of operation.

Where a normal input signal is instead presented to the input 19, this signal will not be sufficient to enable the buffer element 8, and the amplifier will be operating in the master mode.

## Claims

1. A power operational amplifier (7) having at least one input terminal (18, 19) that receives an input signal and an output terminal (20) that delivers a corresponding amplified output signal and comprising at least one input stage (5) and one power stage (6) connected in series in a chain between said at least one input terminal (18, 19) and said output terminal (20), said input stage (5) comprising at least a differential amplifier (9) having first (+) and second (-) input terminals, connected to respective input terminals (18,19) of the operational amplifier (7), and a gain stage (22) connected between the output of said differential amplifier (9) and the input of the power stage (6) for driving said power stage (6); further comprising a control element (8) coupled to the input stage(5) for selectively disabling and enabling the input stage (5) and wherein a drive terminal (BUF_DRV) is available outside the operational amplifier (7) and connected to the input of said power stage (6); **characterized in that** a control terminal of said control element (8) coincides with at least one input terminal (19) of the operational amplifier (7) and said input stage (5) is disabled from the operational amplifier (7) outside by the application of a suitable electric signal to said control terminal of said control element (8) so that the power operational amplifier (7) is alternatively operated in a first mode, whereby both the input (5) and power (6) stages are enabled, or in a second mode whereby the input stage (5) is disabled and the power stage (6) is enabled.

2. An operational amplifier (7) according to Claim 1, **characterized in that** it comprises a compensating capacitor (Ccomp) connected between said output terminal (20) and an input terminal of said gain stage (22).

3. An operational amplifier (7) according to Claim 1, **characterized in that** said power stage (6) has a limited transconductance.

4. An operational amplifier (7) according to Claim 1, **characterized in that** a high positive voltage on said control terminal of said control element (8) set the amplifier (7) for a slave mode operation.

5. An operational amplifier (7) according to Claim 1, **characterized in that** said control element (8) is an N-Channel MOS transistor (M2).

## Patentansprüche

1. Leistungs-Operationsverstärker (7) mit mindestens einem Eingangsanschluss (18, 19), der ein Eingangssignal empfängt, und einem Ausgangsanschluss (20), der ein entsprechendes verstärktes Ausgangssignal liefert, und mit mindestens einer Eingangsstufe (5) und einer Endstufe (6), die in einer Kette zwischen dem mindestens einen Eingangsanschluss (18, 19) und dem Ausgangsanschluss (20) in Reihe verbunden sind, wobei die Eingangsstufe (5) mindestens einen Differentialverstärker (9), der einen ersten (+) und einen zweiten (-) Eingangsanschluss aufweist, die mit jeweiligen Eingangsanschlüssen (18, 19) des Operationsverstärkers (7) verbunden sind, und eine Verstärkungsstufe (22), die zwischen den Ausgang des Differentialverstärkers (9) und den Eingang der Endstufe (6) zum Steuern der Endstufe (6) gekoppelt ist, umfasst; weiter mit einem Steuerelement (8), das mit der Eingangsstufe (5) zum selektiven Sperren und Freigeben der Eingangsstufe (5) verbunden ist, und wobei ein Steueranschluss (BUF_DRV) außerhalb des Operationsverstärkers (7) zur Verfügung steht und mit dem Eingang der Endstufe (6) verbunden ist; **dadurch gekennzeichnet, dass** ein Steueranschluss des Steuerelements (8) sich mit mindestens einem Eingangsanschluss (19) des Operationsverstärkers (7) deckt und die Eingangsstufe (5) außerhalb von dem Operationsverstärker (7) durch Anlegen eines geeigneten elektrischen Signals an den Steueranschluss des Steuerelements (8) gesperrt ist, so dass der Leistungs-Operationsverstärker (7) alternativ in einem ersten Modus betrieben wird, wodurch sowohl die Eingangsstufe (5) als auch die Endstufe (6) freigeben werden, oder in einem zweiten Modus betrieben wird, wodurch die Eingangsstufe (5) gesperrt und die Endstufe (6) freigegeben wird.

**2.** Operationsverstärker (7) nach Anspruch 1, **dadurch gekennzeichnet, dass** er einen Ausgleichskondensator (Ccomp) umfasst, der zwischen den Ausgangsanschluss (20) und einem Eingangsanschluss der Verstärkungsstufe (22) gekoppelt ist.

**3.** Operationsverstärker (7) nach Anspruch 1, **dadurch gekennzeichnet, dass** die Endstufe (6) eine begrenzte Steilheit aufweist.

**4.** Operationsverstärker (7) nach Anspruch 1, **dadurch gekennzeichnet, dass** eine hohe positive Spannung an dem Steueranschluss des Steuerelements (8) den Verstärker (7) für einen Nebenmodusbetrieb einstellt.

**5.** Operationsverstärker (7) nach Anspruch 1, **dadurch gekennzeichnet, dass** es sich bei dem Steuerelement (8) um einen N-Kanal-MOS-Transistor (M2) handelt.

**Revendications**

**1.** Un amplificateur opérationnel de puissance (7) possédant au moins une borne d'entrée (18, 19) qui reçoit un signal d'entrée et une borne de sortie (20) qui délivre un signal de sortie amplifié correspondant et comprenant au moins un étage d'entrée (5) et un étage de puissance (6) reliés en série en une chaîne entre ladite au moins une borne d'entrée (18, 19) et ladite borne de sortie (20), ledit étage d'entrée (5) comprenant au moins un amplificateur différentiel (9) possédant une première (+) et une seconde (-) borne d'entrée, reliées à des bornes d'entrée respectives (18, 19) de l'amplificateur opérationnel, et un étage de gain (22) relié entre la sortie dudit amplificateur opérationnel (9) et l'entrée de l'étage de puissance (6) pour piloter ledit étage de puissance (6) ; comprenant en outre un élément de commande (8) couplé à l'étage d'entrée (5) pour sélectivement désactiver et activer l'étage d'entrée (5) et dans lequel une borne de pilotage (BUF_DRV) est accessible à l'extérieur de l'amplificateur opérationnel et reliée à l'entrée dudit étage de puissance (6) ; **caractérisé en ce qu'**une borne de commande dudit élément de commande (8) coïncide avec au moins une borne d'entrée (19) de l'amplificateur opérationnel (7) et ledit étage d'entrée (5) est désactivé de l'amplificateur opérationnel (7) à l'extérieur par application d'un signal électrique approprié à ladite borne de commande dudit élément de commande (8) de sorte que l'amplificateur opérationnel de puissance (7) est mis en fonctionnement alternativement dans un premier mode, de telle sorte que les étages d'entrée (5) et de puissance (6) soient tous deux activés, ou dans un second mode, de telle sorte que l'étage d'entrée (5) soit désactivé et l'étage de puissance (6) soit activé.

**2.** Un amplificateur opérationnel (7) selon la revendication 1, **caractérisé en ce qu'**il comprend une capacité de compensation (Ccomp) reliée entre ladite borne de sortie (20) et une borne d'entrée dudit étage de gain (22).

**3.** Un amplificateur opérationnel (7) selon la revendication 1, **caractérisé en ce que** ledit étage de puissance (6) présente une transconductance limitée.

**4.** Un amplificateur opérationnel (7) selon la revendication 1, **caractérisé en ce qu'**une tension positive élevée sur ladite borne de commande dudit élément de commande (8) positionne l'amplificateur (7) pour un fonctionnement en mode esclave.

**5.** Un amplificateur opérationnel (7) selon la revendication 1, **caractérisé en ce que** ledit élément de commande (8) est un transistor MOS à canal N (M2).

FIG.1

FIG.2

FIG.3

FIG.4

FIG.5

FIG.6